# EUROPÄISCHE PATENTSCHRIFT

(11) **EP 2 629 419 B1**
(45) Veröffentlichungstag und Bekanntmachung des Hinweises auf die Patenterteilung: **09.08.2017**
(21) Anmeldenummer: 12155675.7
(22) Anmeldetag: 15.02.2012
(51) Int. Cl.: H03K 5/04, H03K 5/08

(54) **Vorrichtung zur Erzeugung von kurzen elektrischen Impulsen**
Device for generating short electric impulses
Dispositif destiné à la production d'impulsions électriques courtes

(43) Veröffentlichungstag der Anmeldung: 21.08.2013
(73) Patentinhaber: VEGA Grieshaber KG, 77709 Wolfach (DE)
(72) Erfinder: Corbe, Bernhard, 77746 Schutterwald (DE); Fischer, Michael, 72275 Alpirsbach (DE)
(74) Vertreter: Westphal, Mussgnug & Partner Patentanwälte mbB

(56) Entgegenhaltungen:
- EP-A2- 1 528 679
- JP-A- 57 204 926
- US-A- 3 867 648
- US-A1- 2007 296 384
- US-B1- 6 380 815

## Beschreibung

Die vorliegende Erfindung betrifft eine Vorrichtung zur Erzeugung von kurzen elektrischen Impulsen.

Vorrichtungen zur Erzeugung kurzer elektrischer Impulse weisen in der Regel einen Basisgenerator zur Erzeugung von Basismonopulsen auf, an dem ausgangsseitig ein Basismonopuls abgreifbar ist.

Die Dokumente US 3,867,648 und EP 1528679 A2 offenbaren zwei unterschiedliche Schaltungen zur Erzeugung von kurzen elektrischen Impulsen durch Verkürzung von Eingangsimpulsen. Es ist die Aufgabe der vorliegenden Erfindung, einen weitergebildeten Impulsgenerator zur Verfügung zu stellen, der möglichst kurze und gaußförmige Monopulse erzeugt, die sich durch sehr geringes Überschwingen auszeichnen.

Diese Aufgabe wird durch eine Vorrichtung mit den Merkmalen des Patentanspruchs 1 gelöst.

Eine erfindungsgemäße Vorrichtung zur Erzeugung kurzer elektrischer Impulse weist einen Basisgenerator zur Erzeugung von Basismonopulsen im Subnanosekundenbereich auf, wobei dem Basisgenerator eine Transistorstufe nachgeschaltet ist.

Als Basisgenerator kann bspw. ein Impulsgenerator, der ausgangsseitig kurze Monopulse, d. h. monopolare Spannungspulse im Subnanosekundenbereich zur Verfügung stellt, zum Einsatz kommen. Dem Basisgenerator ist dann zur Erzeugung eines weiter verkürzten elektrischen Impulses eine Transistorstufe nachgeschaltet, die bevorzugt in Emitterschaltung betrieben wird. Auf diese Weise kann die hohe Stromverstärkung eines in Emitterschaltung betriebenen Bipolartransistors ausgenutzt werden. Durch die Verwendung eines aktiven Schaltelementes kann außerdem verhindert werden, dass die durch diese Schaltung erzeugte ausgangsseitige Signalamplitude des elektrischen Impulses absinkt.

Um eine weitere Verkürzung des ausgangsseitig erhältlichen elektrischen Impulses zu erreichen, ist der Transistorstufe ein Dämpfungsglied vorgeschaltet. An diesem Dämpfungsglied ist ausgangsseitig ein gedämpfter Basismonopuls abgreifbar, der der Transistorstufe zugeführt ist. Durch das Vorsehen des Dämpfungsgliedes wird erreicht, dass nur ein bestimmter Teil des Basismonopulses zur Aussteuerung der Transistorstufe beiträgt. Bezogen auf die Pulsbreite des Basismonopulses fließt während eines kürzeren Zeitraums ein Strom in der Basis-Emitter-Diode der nachfolgenden Transistorstufe. Diese Reduktion des Stromflusswinkels bewirkt an der nichtlinearen Kennlinie des Transistors eine Erhöhung des O-berwellenanteils und damit eine Verkürzung der Impulsbreite. Das Dämpfungsglied kann außerdem unerwünschte Über- und Unterschwinger des Basismonopulses aus dem Basisgenerator unterdrücken. Das Dämpfungsglied kann beispielsweise als Pi-Glied, T-Glied oder als Spannungsteiler ausgebildet sein. Die Transistorstufe kann unter Vorspannung betrieben werden.

Zur Vorspannung der Transistorstufe ist eine Gleichspannungsquelle vorgesehen. Diese Gleichspannungsquelle liegt an dem Basisanschluss der Transistorstufe an, so dass der Transistorstufe eine Überlagerung der Gleichspannung und des gedämpften Basismonopulses zugeführt ist.

Die Gleichspannung und der gedämpfte Basismonopuls sind derart aufeinander abgestimmt, dass die Transistorstufe durch eine Summe aus der Gleichspannung und dem gedämpften Basismonopuls gerade nicht in Sättigung gebracht wird. Die Polarität der Gleichspannung kann positiv oder negativ sein, wobei eine positive Gleichspannung derart klein bemessen ist, dass ohne Basismonopuls kein Kollektorstrom zum Fließen kommt.

In einer Weiterbildung der erfindungsgemäßen Vorrichtung ist die Vorspannung der Transistorstufe einstellbar.

Durch eine Einstellbarkeit der Vorspannung kann insbesondere erreicht werden, dass Fertigungstoleranzen ausgeglichen werden können. Eine Einstellbarkeit der Vorspannung ermöglicht außerdem, eine gewünschte Breite oder Amplitude des ausgangsseitigen Impulses einzustellen. Der erfindungsgemäße Impulsgenerator ist damit gegenüber der aus dem Stand der Technik bekannten Generatoren wesentlich flexibler einsetzbar.

Zur Einstellung der Vorspannung kann beispielsweise an der Gleichspannungsquelle eine Einstelleinrichtung vorgesehen sein. Diese Einstelleinrichtung kann beispielsweise als digital-analog-Wandler oder als analoges oder digitales Potentiometer ausgebildet sein. Auf diese Weise ist eine manuelle Einstellung der Vorspannung möglich, kann aber auch eine vollautomatische Einstellung aufgrund eines zur Verfügung gestellten Steuersignals erreicht werden.

Um nicht nur fertigungstechnische Variationen sondern auch temperaturinduzierte Veränderungen ausgleichen zu können, kann eine Temperaturkompensationseinrichtung vorgesehen sein. Bevorzugt ist die Temperaturkompensationseinrichtung derart ausgebildet, dass sie die Gleichspannungsquelle derart einstellt, dass ein Temperaturgang der Vorrichtung kompensiert wird.

Die Temperaturkompensationseinrichtung kann dazu insbesondere einen Thermistor aufweisen, so dass die Transistorstufe mit einer temperaturabhängigen Gleichspannung vorgespannt betrieben wird. Alternativ können aber auch mittels Digitalpotentiometern oder D/A-Wandlern temperaturabhängige Gleichspannungen zur Kompensation eines Temperaturganges eingespeist werden. Insbesondere kann die Temperaturkompensationseinrichtung auf das analoge oder digitale Potentiometer derart wirken, dass der Transistorstufe eine dem Temperaturgang der Vorrichtung angepasste Gleichspannung zugeführt wird.

Der Transistorstufe können außerdem ein Differenzierglied und eine Clippingeinrichtung nachgeschaltet sein. Der so erzielte Ausgangsimpuls wird im Vergleich zu dem an der Transistorstufe abgreifbaren Impuls zwar eine verkleinerte Amplitude aufweisen, ist insgesamt aber schmaler. Das Verhältnis von Schmalheit zu Amplitude der Impulse wird damit im Vergleich zum Stand der Technik verbessert.

Die vorliegende Erfindung wird nachfolgend anhand zweier Ausführungsbeispiele unter Bezugnahme auf die beigefügten Figuren eingehend erläutert. Es zeigen:
- Figur 1: ein erstes Ausführungsbeispiel einer erfindungsgemäßen Vorrichtung und
- Figur 2: eine Messung des Ausgangspulses der erfindungsgemäßen Vorrichtung und
- Figur 3: eine Weiterbildung zu dem Ausführungsbeispiel aus Figur 1.

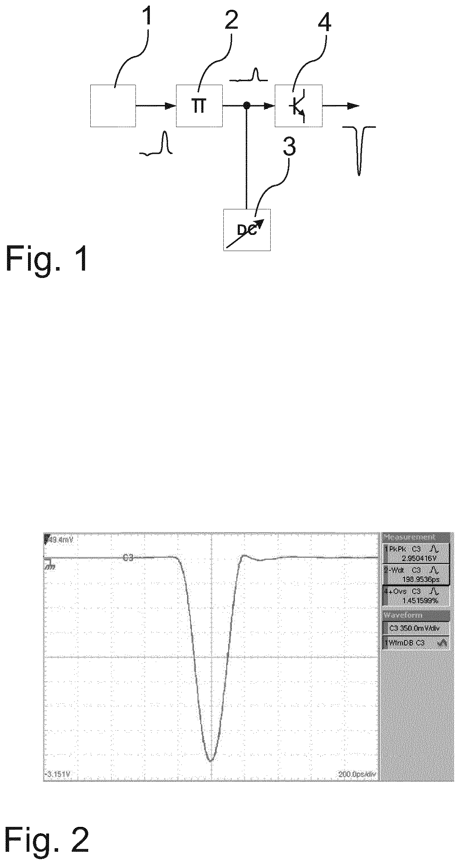

Figur 1 zeigt ein erstes Ausführungsbeispiel einer erfindungsgemäßen Vorrichtung zur Erzeugung kurzer elektrischer Impulse, d.h. monopolaren Spannungsimpulsen die im Wesentlichen gaußförmig ausgestaltet sind mit einem Basisgenerator 1 zur Erzeugung von Basismonopulsen im Subnanosekundenbereich.

Wie bereits erwähnt ist dieser Aufbau des Basisgenerators 1 lediglich als beispielhaft anzusehen. Grundsätzlich kann als Basisgenerator 1 jeder Impulsgenerator eingesetzt werden, der ausgangsseitig monopolare elektrische Impulse im Subnanosekundenbereich zur Verfügung stellt.

Der Ausgangspuls des Basisgenerators 1 bestimmt im Wesentlichen die Pulsbreite der Gesamtschaltung. Liefert er Impulse im Subnanosekundenbereich, werden auch die Ausgangspulse der gesamten Anordnung in diesem Bereich liegen. Die gemessene zusätzliche Impulsverkürzung liegt in der Größenordnung von 30%.

Im vorliegenden Ausführungsbeispiel ist dem Basisgenerator 1 ein Dämpfungsglied 2 nachgeschaltet, das den an dem Basisgenerator abgreifbaren Basismonopuls derart abschwächt, dass ausgangsseitig nur der oberste Teil des Basismonopulses wirksam wird. Das Dämpfungsglied 2 kann beispielsweise als resistives Pi-Glied, T-Glied oder als einfacher Spannungsteiler ausgeführt sein. Prinzipiell ist jedes Schaltungsnetzwerk geeignet, das den im Basisgenerator erzeugten Basismonopuls soweit abschwächt, dass nur die schmale und steile Impulsspitze zur Ansteuerung einer Transistorstufe 4 beiträgt. Ein weiterer Vorteil der Verwendung eines Dämpfungsgliedes 2 besteht darin, dass unerwünschte Signalanteile wie beispielsweise Unter- oder Überschwinger, die aufgrund parasitärer Kapazitäten und Induktivitäten im Schaltungsaufbau entstehen, unterdrückt werden.

Durch die Dämpfung des Basismonopulses mithilfe des Dämpfungsgliedes 2 wird erreicht, dass der Stromflusswinkel, der zur Aussteuerung der nachgeschalteten Transistorstufe anliegt, weiter reduziert wird. Um eine zuverlässige Ansteuerung der Transistorstufe 4 zu gewährleisten und um die gewünschte Ausgangsamplitude bzw. Pulsbreite einstellen zu können, ist dem gedämpften Basismonopuls eine Gleichspannung aus einer Gleichspannungsquelle 3 überlagert. Die Gleichspannung ist derart eingestellt, dass ohne Überlagerung mit dem gedämpften Basismonopuls kein Kollektorstrom in der Transistorstufe 4 fließt.

Durch Überlagerung der Gleichspannung mit dem gedämpften Basismonopuls wird je nach Höhe der Gleichspannung sowohl die Amplitude als auch der Stromflusswinkel des Ansteuerimpulses verändert, wodurch sich eine Steuermöglichkeit der Ausgangsimpulse ergibt.

Wie im vorliegenden Ausführungsbeispiel gezeigt, ist die Gleichspannungsquelle 3 bevorzugt einstellbar ausgebildet, so dass eine Anpassung der Gleichspannung an Herstellungsschwankungen oder an einen Temperaturgang der Vorrichtung möglich ist. Darüber hinaus ist es durch Variation der eingangsseitig an der Transistorstufe 4 anliegenden Gleichspannung möglich eine ausgangsseitige Amplitude bzw. Impulsbreite einstellbar zu gestalten, so dass zwischen minimaler und maximaler Amplitude ein Einstellbereich mit einem Faktor > 3 erzielt werden kann. Außerdem ist eine Kompensation des Temperaturgangs der Schaltung möglich. Dazu kann beispielsweise ein Thermistor mit Widerstandsnetzwerk, der direkt auf die angelegte Gleichspannung wirkt, oder eine Regeleinrichtung vorgesehen sein. Eine solche Regeleinrichtung detektiert die ausgangsseitige Amplitude und bewirkt eine Nachregelung der Gleichspannung, beispielsweise über ein eingesetztes Digitalpotentiometer.

In Figur 2 ist ein gemessener Ausgangspuls des beschriebenen Verfahrens dargestellt, bei dem die Impulsbreite auf ca. 200ps abgeglichen wurde. Bei einer Ausgangsamplitude von etwa 3 Volt liegt der Überschwinger bei < 1.5% was einer Unterdrückung von etwa 36dB entspricht.

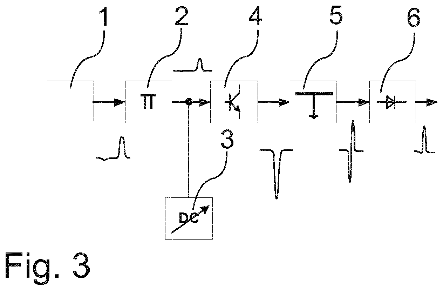

Figur 3 zeigt eine Weiterbildung der Schaltung aus Figur 1.

In dem in Figur 3 dargestellten Ausführungsbeispiel sind der Transistorstufe 4 ausgangsseitig eine Differenzierstufe 5 sowie eine Clippingeinrichtung 6 nachgeschaltet. Die Differenzierstufe 5 erzeugt aus dem an der Transistorstufe 4 abgreifbaren Ausgangssignal einen in der Impulsbreite weiter verkürzten aber aufgrund der Eigenschaften der Differenzierstufe 5 bipolaren elektrischen Impuls. Um aus diesem bipolaren elektrischen Impuls wieder einen Monopuls zu erhalten ist der Differenzierstufe 5 die Clippingeinrichtung 6, die beispielsweise als Schottky-Diode ausgebildet ist, nachgeschaltet.

### Bezugszeichenliste

- 1: Basisgenerator
- 2: Dämpfungsglied
- 3: Gleichspannungsquelle
- 4: Transistorstufe
- 5: Differenzierstufe
- 6: Clippingeinrichtung

## Patentansprüche

1. Vorrichtung zur Erzeugung von kurzen elektrischen Impulsen mit einem Basisgenerator (1) zur Erzeugung von Basismonopulsen, im Subnanosekundenbereich, wobei dem Basisgenerator (1) eine Transistorstufe (4) nachgeschaltet ist, eine Gleichspannungsquelle (3) an einem Basisanschluss der Transistorstufe (4) anliegt, die Transistorstufe (4) über eine Gleichspannung aus der Gleichspannungsquelle (3) unter Vorspannung betrieben wird, der Transistorstufe (4) ein Dämpfungsglied (2) vorgeschaltet ist, an dem ausgangsseitig ein gedämpfter Basismonopuls abgreifbar ist, der Transistorstufe (4) eine Überlagerung der Gleichspannung und des gedämpften Basismonopulses zugeführt ist, und die Gleichspannung und der gedämpfte Basismonopuls so aufeinander abgestimmt sind, dass die Transistorstufe (4) durch eine Summe aus der Gleichspannung und dem gedämpften Basismonopuls gerade nicht in Sättigung gebracht wird.

2. Vorrichtung nach Anspruch 1,
**dadurch gekennzeichnet, dass** das Dämpfungsglied (2) als Pi-Glied, T-Glied oder als Spannungsteiler ausgebildet ist.

3. Vorrichtung nach Anspruch 1 oder 2,
**dadurch gekennzeichnet, dass** die Vorspannung einstellbar ist.

4. Vorrichtung nach einem der vorhergehenden Ansprüche,
**dadurch gekennzeichnet, dass** die Gleichspannungsquelle (3) über eine Einstelleinrichtung einstellbar ist.

5. Vorrichtung nach Anspruch 4,
**dadurch gekennzeichnet, dass** die Einstelleinrichtung als digital-analog-Wandler ausgebildet ist.

6. Vorrichtung nach Anspruch 4,
**dadurch gekennzeichnet, dass** die Einstelleinrichtung als analoges oder digitales Potentiometer ausgebildet ist.

7. Vorrichtung nach einem der vorhergehenden Ansprüche,
**dadurch gekennzeichnet, dass** eine Temperaturkompensationseinrichtung vorgesehen ist.

8. Vorrichtung nach Anspruch 7,
**dadurch gekennzeichnet, dass** die Temperaturkompensationseinrichtung die Gleichspannungsquelle (3) derart einstellt, dass ein Temperaturgang der Vorrichtung kompensiert wird.

9. Vorrichtung nach Anspruch 8,
**dadurch gekennzeichnet, dass** die Temperaturkompensationseinrichtung einen Thermistor aufweist.

10. Vorrichtung nach Anspruch 8,
**dadurch gekennzeichnet, dass** die Kompensationseinrichtung auf das analoge oder digitale Potentiometer wirkt.

11. Vorrichtung nach einem der vorhergehen Ansprüche,
**dadurch gekennzeichnet, dass** der Transistorstufe ein Differenzierglied (5) und eine Clippingeinrichtung (6) nachgeschaltet sind.

12. Vorrichtung nach Anspruch 11,
**dadurch gekennzeichnet, dass** die Clippingeinrichtung(6) als Schottky-Diode ausgebildet ist.

## Claims

1. Device for generating short electrical pulses having a base generator (1) for generating base monopulses, in the sub-nanosecond range, wherein a transistor stage (4) is connected downstream of the base generator (1), a DC voltage source (3) is applied to a base terminal of the transistor stage (4), the transistor stage (4) is operated under bias voltage via a DC voltage from the DC voltage source (3), an attenuator (2) is connected upstream of the transistor stage (4), on which attenuator an attenuated base monopulse can be tapped on the output side, a superposition of the DC voltage and the attenuated base monopulse is supplied to the transistor stage (4), and the DC voltage and the attenuated base monopulse are adjusted with respect to each other in such a way that the transistor stage (4) is not brought into saturation by a total of the DC voltage and the attenuated base monopulse.

2. Device according to claim 1,
**characterised in that**
the attenuator (2) is formed as a Pi pad, T pad or as a voltage divider.

3. Device according to claim 1 or 2,
**characterised in that**
the bias voltage can be adjusted.

4. Device according to one of the preceding claims,
**characterised in that**
the DC voltage source (3) can be adjusted by means of an adjustment device.

5. Device according to claim 4,
**characterised in that**
the adjustment device is formed as a digital-to-analogue converter.

6. Device according to claim 4,
**characterised in that**
the adjustment device is formed as an analogue or digital potentiometer.

7. Device according to one of the preceding claims,
**characterised in that**
a temperature compensation device is provided.

8. Device according to claim 7,
**characterised in that**
the temperature compensation device adjusts the DC voltage source (3) in such a way that a temperature response of the device is compensated for.

9. Device according to claim 8,
**characterised in that**
the temperature compensation device has a thermistor.

10. Device according to claim 8,
**characterised in that**
the compensation device acts on the analogue or digital potentiometer.

11. Device according to one of the preceding claims,
**characterised in that**
a differentiator (5) and a clipping device (6) are connected downstream of the transistor stage.

12. Device according to claim 11,
**characterised in that**
the clipping device (6) is formed as a Schottky diode.

## Revendications

1. Dispositif pour générer des impulsions électriques courtes avec un générateur de base (1) pour générer des mono-impulsions de base dans le domaine des sous-nanosecondes,
le générateur de base (1) étant suivi d'un étage à transistor (4), d'une source de tension continue (3) reliée à la borne de base de l'étage de transistor (4), cet étage de transistor (4) étant piloté par une tension continue fournie par la source de tension continue (3) en polarisation, l'étage de transistor (4) étant précédé d'un élément amortisseur (2) dont la sortie fournit une mono-impulsion de base, amortie, l'étage de transistor (4) recevant la combinaison de la tension continue et de la mono-impulsion de base amortie, la tension continue et la mono-impulsion de base amortie étant définies l'une par rapport à l'autre pour que l'étage de transistor (4) ne soit pas juste mis en saturation par la somme de la tension continue et de la mono-impulsion de base amortie.

2. Dispositif selon la revendication 1,
**caractérisé en ce que**
l'élément amortisseur (2) est un élément PI, un élément T et/ou un diviseur de tension.

3. Dispositif selon la revendication 1 ou 2,
**caractérisé en ce que**
la polarisation est réglable.

4. Dispositif selon l'une des revendications précédentes,
**caractérisé en ce que**
la source de tension continue (3) est réglée par une installation de réglage.

5. Dispositif selon la revendication 4,
**caractérisé en ce que**
l'installation de réglage est réalisée sous la forme d'un convertisseur numérique-analogique.

6. Dispositif selon la revendication 4,
**caractérisé en ce que**
l'installation de réglage est réalisée sous la forme d'un potentiomètre analogique ou numérique.

7. Dispositif selon l'une des revendications précédentes,
**caractérisé en ce qu'**
il comporte une installation de compensation de température.

8. Dispositif selon la revendication 7,
**caractérisé en ce que**
l'installation de compensation de température règle la source de tension continue (3) pour compenser le profil de température du dispositif.

9. Dispositif selon la revendication 8,
**caractérisé en ce que**
l'installation de compensation de température comporte une thermistance.

10. Dispositif selon la revendication 8,
**caractérisé en ce que**
l'installation de compensation agit sur le potentiomètre analogique ou numérique.

11. Dispositif selon l'une des revendications précédentes,
**caractérisé en ce que**
l'étage de transistor est suivi d'un élément différentiel (5) d'une installation de d'écrêtage (6).

12. Dispositif selon la revendication 11,
**caractérisé en ce que**
l'installation d'écrêtage (6) est sous la forme d'une diode Schottky.
